# EUROPÄISCHE PATENTANMELDUNG

(11) **EP 1 772 738 A2**
(43) Veröffentlichungstag der Anmeldung: **11.04.2007**
(21) Anmeldenummer: 06400032.6
(22) Anmeldetag: 04.10.2006
(51) Int. Cl.: G01R 31/12, G01R 31/14

(54) **Verfahren zur Diagnose der Alterung von elektrischen Anlagen mittels Verlustfaktormessungen mit Frequenzen kleiner als die Frequenzen der öffentlichen, elektrischen Versorgungsnetze**

(30) Priorität: 04.10.2005 DE 102005050112
(71) Anmelder: Wimmershoff, Rudolf, Prof. Dr.-Ing., 93080 Pentling bei Regensburg (DE)
(72) Erfinder: Wimmershoff, Rudolf, Prof. Dr.-Ing., 93080 Pentling bei Regensburg (DE)

(57) **Zusammenfassung**

Die Erfindung betrifft ein Verfahren zur Diagnose der Alterung und Zersetzung ohne den Nachteil von Ableitverlusten bei Werkstoffen aller Art und jeder geometrischen Größe mittels Verlustfaktormessungen mit Frequenzen kleiner als die Frequenzen der öffentlichen, elektrischen Versorgungsnetze.

Die Erfindung gibt ein Verfahren an, welches bei geringem technischem und finanziellem Aufwand eine empfindliche Diagnose der Alterung und Zersetzung von Werkstoffen erlaubt.

Es handelt sich um Werkstoffe aller Art und jeder geometrischen Größe, die z. B. bei Anlagen und Geräten eingesetzt werden sowie um Werkstoffe, deren Alterung und Zersetzung mittels kapazitiver Fühler oder Sonden im Online- oder Offlinebetrieb bestimmt werden.

Dieses Verfahren beruht auf Verlustfaktormessungen, z.B. mit Spannungen mit 0,1 Hz und wird, z.B. direkt vor Ort bei Transformatoren, Induktivitäten, Durchführungen von Transformatoren und Induktivitäten sowie Kapazitäten und Kabeln im Onlinebetrieb ohne den Nachteil von Ableitverlusten eingesetzt.

Wie aus Bild 2 zu erkennen ist, sind Verlustfaktorwerte tan δ für Transformatoren in Abhängigkeit der Prüfspannung vergleichsweise für Messungen mit Einfluss der Ableitverluste und ohne diesen Einfluss dargestellt.

## Beschreibung

Die vorliegende Erfindung betrifft ein Verfahren zur Diagnose der Alterung und Zersetzung ohne Einfluss von Ableitverlusten
- bei Werkstoffen aller Art und jeder geometrischen Größe, z. B. Dielektrika von Anlagen und Geräten selbst, sowie
- bei Werkstoffen, deren Alterung mittels kapazitiver Fühler und Sonden im Online- oder Offlinebetrieb, z. B. Anlagen und Geräten
   mittels Verlustfaktormessungen, z. B. mit 0,1 Hz; also mit Frequenzen, die kleiner sind, als die Frequenzen 50 Hz bzw. 60 Hz der öffentlichen, elektrischen Versorgungsnetze, z.B. für den Betrieb von Transformatoren, Induktivitäten, Kapazitäten und Kabel.

Vorteil dieses Verfahrens gegenüber dem Stand der Technik ist es, dass der Verlustfaktor, z. B. bei 0,1 Hz nicht nur integral für die gesamte Anlage oder das gesamte Gerät (1. Messanschluss auf Prüfspannung und 2. Messanschluss auf Erdpotential) bestimmt werden kann, sondern jetzt jedes Dielektrikum einer Einzelkomponente, die über eine elektrische Durchführung angeschlossen werden kann, ohne den Einfluss von

Ableitverlusten zu messen ist.

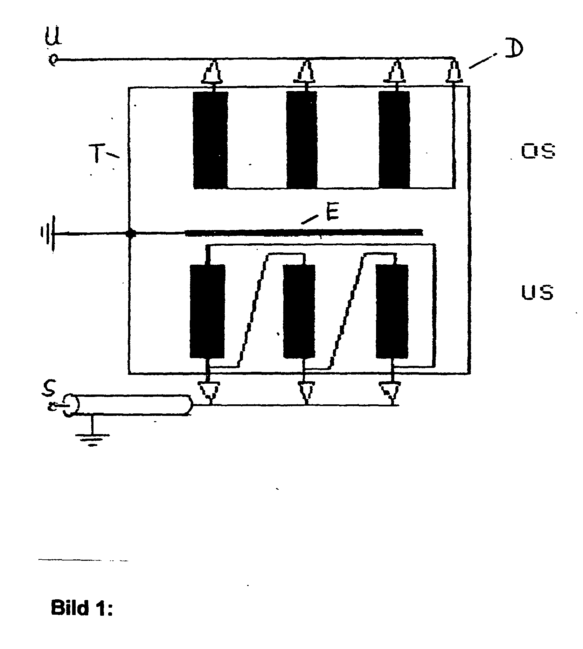

In Bild 1 ist das Ersatzschaltbild eines Prüflings, hier ein Leistungstransformator für die Messung der Hauptisolation separat zwischen der Oberspannungswicklung (OS) und der Unterspannungswicklung (US) mit Hilfe des Verlustfaktors mit 0,1 Hz dargestellt. Die Prüfspannung (U) liegt an den Durchführungen der Oberspannungswicklung (OS). Der Messsignalanschluss (S) liegt erdfrei von der Anlage an der Unterspannungswicklung. Der Transformatorkessel (T) und der Eisenkern des Transformators (E) sind mit der

Anlagenerde verbunden.

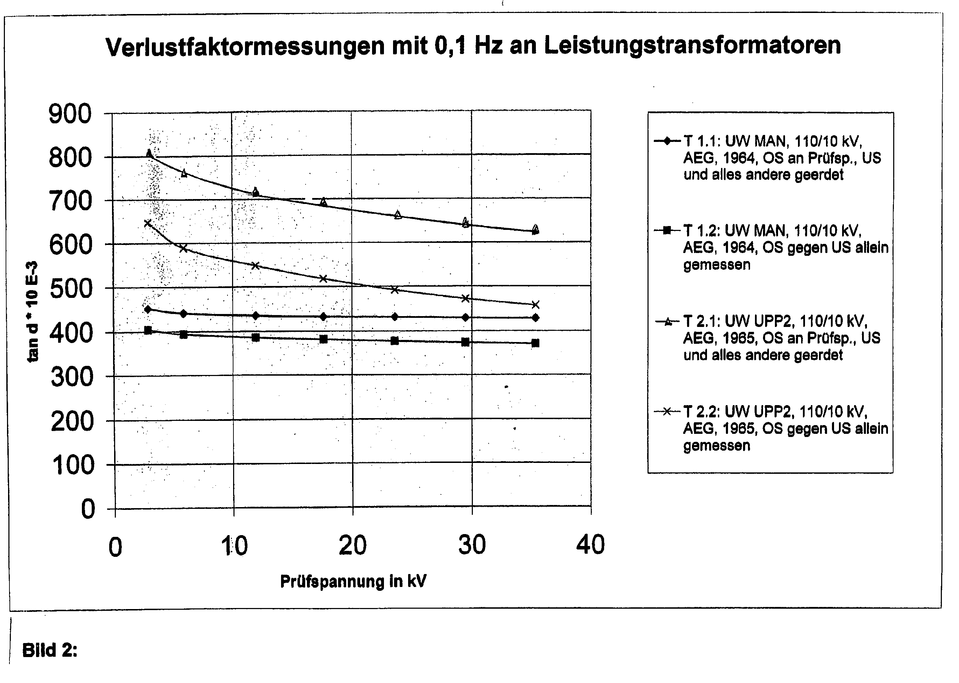

Wie aus **Bild 2** zu erkennen ist, ist der Verlustfaktor tan δ in Abhängigkeit von der Prüfspannung, aufgetragen für folgende Leistungstransformatoren, dargestellt:
- T1.1, Messung des gesamten Transformators, OS gegen geerdete US, alle anderen Teile des Transformators geerdet.
- T1.2, gleicher Transformator wie T1.1, aber OS gegen nicht geerdete US, alle sonstigen Teile des Transformators geerdet.
- T2.1, Messung des gesamten Transformators, OS gegen geerdete US, alle anderen Teile des Transformators geerdet.
- T2.2, gleicher Transformator wie T2.1, aber OS gegen nicht geerdete US, alle sonstigen Teile des Transformators geerdet.

Aus dem **Bild 2** erkennt man die jeweiligen deutlichen Unterschiede der Messungen des Dielektrikums des gesamten Transformators T2.1 zur Messung am Dielektrikum zwischen der Oberspannungswicklung und der Unterspannungswicklung separat, T2.2.

Die Verlustfaktorwerte der Messung am gesamten Transformator liegen im Vergleich zur Messung zwischen Oberspannungswicklung und Unterspannungswicklung separat höher. Der Grund ist, dass bei der Messung am gesamten Transformator die Durchführungen, die Ableitverluste zum geerdeten Transformatorkessel, zum geerdeten Kern und ein Teil der Ableitverluste über den Stufenschalter des Transformators mitgemessen werden.

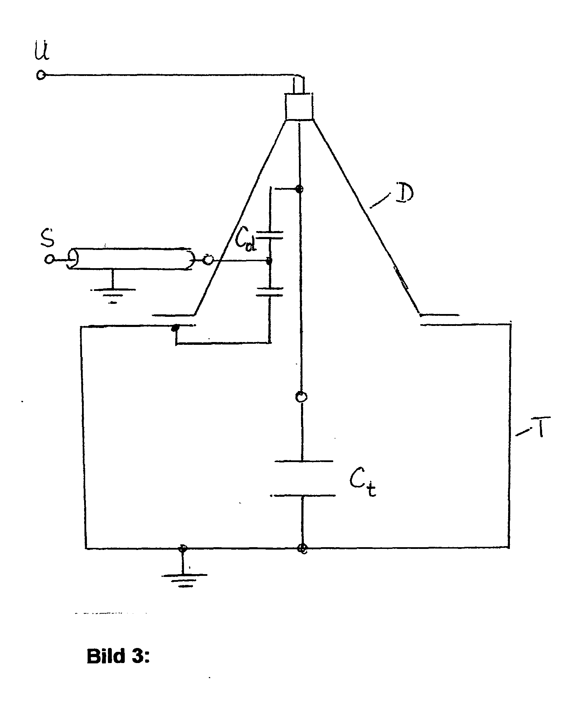

Wie in dem **Bild 3** dargestellt ist, können mit dem hier vorgeschlagenen Verfahren auch Transformatordurchführungen separat, jede für sich, mittels Verlustfaktormessung, z. B. mit 0,1 Hz erdfrei von der Anlage bezüglich der Alterung und Zersetzung diagnostiziert werden. Aus diesem Bild ist das prinzipielle Ersatzschaltbild einer Transformatordurchführung zu entnehmen. Die Prüfspannung (U) wird an die Durchführung mit der Kapazität (C_{d}) angelegt und das Messsignal an dem Signalanschluss (S) abgegriffen.

Aus dem **Bild 4** ist zu entnehmen, dass die älteren Durchführungen (D3) und (D4) sich deutlich von den neuen Durchführungen (D1) und (D2) durch ihre höheren Verlustfaktorwerte (höhere Alterungs- und Zersetzungszustände) unterscheiden.

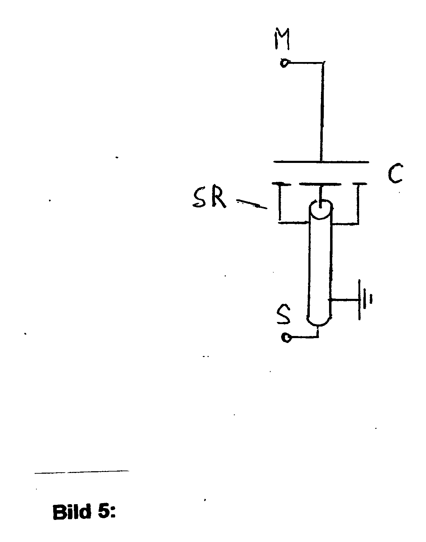

Darüber hinaus lassen sich mit Verlustfaktormessungen, z. B. mit 0,1 Hz mit Hilfe von kapazitiven Messfühlern oder kapazitiven Sonden erdfrei in elektrischen Anlagen oder Geräten, z. B. in Transformatoren, Drosselspulen, Kabelanlagen und anderen Werkstoffen Diagnoseuntersuchungen zur Alterung und Zersetzung von Werkstoffen ohne den Einfluss von Ableitverlusten durchführen. Ein prinzipielles, elektrisches Ersatzbild ist in **Bild 5** dargestellt.

Mit einem kapazitiven Messfühler wurden Verlustfaktormessungen mit einer elektrischen Feldstärke von 0,4 kV/mm an unterschiedüchen Transformatoröten bezogen auf den Neuzustand bei Raumtemperatur durchgeführt, wobei sich folgende Werte ergaben:
- tan δ = 71 * 10⁻³: Typ Nytso 10 BN
- tan δ = 819 * 10⁻³: Mineralöl aus dem Stufenschalter des Transformators: Firma Lepper 110/30 kV, Fabrikations-Nr. 663090, 1967

Der Verlustfaktorwert des erstgenannten Transformatoröles ergibt, dass dieses Öl kaum gealtert und zersetzt ist. Der Verlustfaktorwert des zweiten Öls zeigt eine wesentlich stärkere Alterung und Zersetzung des Öls.

### Literaturverzeichnis

Patentschrift DE 101 35 915 B4 2004.12.02

### Bildunterschriften

**Bild 1**: Prinzipielles, elektrisches Ersatzschaltbild eines Prüflings, hier ein Leistungstransformator für die Messung des Verlustfaktors mit 0,1 Hz, Messsianalanschluss nicht geerdet:
- (OS): Oberspannungswicklung
- (US): Unterspannungswicklung
- (E): Eisenkern des Transformators
- (T): Transformatorkessel
- (U): Prüfspannung
- (S): Signalanschluss

**Bild 2:** Vergleich zwischen den Verlustfaktoren tan δ bei 0,1 Hz in Abhängigkeit der Prüfspannungen an Leistungstransformatoren, gemessen jeweils am gesamten Transformator und der Hauptisolation alleine, d. h. zwischen der Oberspannungswicklung (OS) und der Unterspannungswicklung (US):
- T1.1, Messung des gesamten Transformators, OS gegen geerdete US, alle anderen Teile des Transformators ebenfalls geerdet.
- T1.2, gleicher Transformator wie T1.1, aber OS gegen nicht geerdete US, alle sonstigen Teile des Transformators geerdet.
- T2.1, Messung des gesamten Transformators, OS gegen geerdete US, alle anderen Teile des Transformators ebenfalls geerdet.
- T2.2, gleicher Transformator wie T2.1, aber OS gegen nicht geerdete US, alle sonstigen Teile des Transformators geerdet.

**Bild 3:** Prinzipielles, elektrisches Ersatzschaltbild eines Prüflings, hier eine Durchführung eines Leistungstransformators (einphasig) für die Messung des Verlustfaktors mit 0,1 Hz mit Hilfe eines Messsignalanschlusses:
- (D): Transformatordurchführung
- (T): Transformatorkessel
- (U): Prüfspannung
- (C_{d}): Kapazität der Durchführung
- (S): Signalanschluss
- (Cₜ): Kapazität des Transformators, dabei sind geerdet: Unterspannungswicklung, Transformatorkessel, Eisenkern

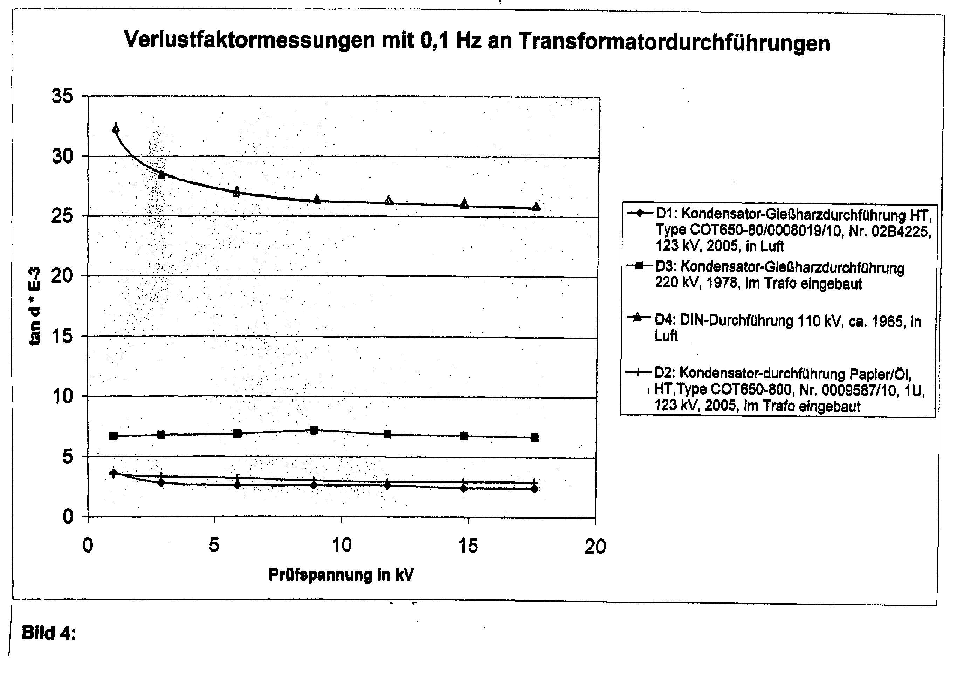

**Bild 4:** Verlustfaktor tan δ bei 0,1 Hz in Abhängigkeit der Prüfspannung, hier gemessen an unterschiedlich gealterten und zersetzten Durchführungen von Leistungstransformatoren

**Bild 5:** Prinzipielles, elektrisches Ersatzschaltbild eines Prüflings ohne oder mit Schutzring, hier ein Messfühler oder Sensor mit sehr kleiner Kapazität, z. B. C = 3 pF für die Messung des Verlustfaktors mit 0,1 Hz an Werkstoffen, z. B. Flüssigkeiten:
- (C): Kapazität des Messfühlers oder des Sensors
- (M): Messspannung
- (S): Signalanschluss
- (SR): Schutzring

## Patentansprüche

1. Verfahren zur Diagnose der Alterung und Zersetzung, dass ohne den Nachteil von Ableitverlusten bei Werkstoffen aller Art und jeder geometrischen Größe mittels Verlustfaktormessungen mit Frequenzen kleiner als die Frequenzen der öffentlichen, elektrischen Versorgungsnetze durchgeführt wird,.
wobei durch das Verfahren an Einzelkomponenten, z. B. von elektrischen Anlagen und Geräten mit Hilfe des Verlustfaktors tan δ, z. B. mit der Frequenz von 0,1 Hz mit hoher Empfindlichkeit die Alterungsdiagnose jeweils durch Leitungsverluste, hervorgerufen durch elektrische Ladungsträger und durch alle Polarisationsverluste, messtechnisch erfasst und verglichen mit dem Neuzustand dieser Einzelkomponenten bestimmt werden, indem das Messsignal am Signalanschluss der jeweiligen Anlagen und Geräte abgegriffen wird.

2. Verfahren nach Anspruch 1, mit dem Verlustfaktorwerte, z. B. mit der Frequenz von 0,1 Hz als Maß für die Diagnose der Alterung und Zersetzung von Werkstoffen mit Hilfe von kapazitiven Messfühlern oder kapazitiven Sonden bestimmt werden.

3. Verfahren nach Anspruch 1, bei dem es sich um Einzelkomponenten, z. B um die Hauptisolierung allein zwischen der Oberspannungswicklung und der Unterspannungswicklung eines Transformators oder um die einzelnen Transformatordurchführungen handelt.
